(19) Europäisches Patentamt
European Patent Office
Office européen des brevets

(11) **EP 3 321 657 B1**

(12) **EUROPÄISCHE PATENTSCHRIFT**

(45) Veröffentlichungstag und Bekanntmachung des Hinweises auf die Patenterteilung:
**08.01.2020 Patentblatt 2020/02**

(51) Int Cl.:
*G01M 17/007* (2006.01)  *B60T 17/22* (2006.01)
*G01L 5/28* (2006.01)

(21) Anmeldenummer: **17200957.3**

(22) Anmeldetag: **10.11.2017**

(54) **VERFAHREN ZUM TEST EINER BREMSANLAGE EINES FAHRZEUGES**

METHOD FOR TESTING THE BRAKE SYSTEM OF A VEHICLE

PROCÉDÉ D'ESSAI D'UNE INSTALLATION DE FREINAGE D'UN VÉHICULE AUTOMOBILE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **11.11.2016 AT 510252016**

(43) Veröffentlichungstag der Anmeldung:
**16.05.2018 Patentblatt 2018/20**

(73) Patentinhaber: **AVL List GmbH**
**8020 Graz (AT)**

(72) Erfinder:
• **KOKAL, Helmut**
**8020 GRAZ (AT)**
• **MONSCHEIN, Martin**
**7564 DOBERSDORF (AT)**
• **ARCE ALONSO, Gorka**
**8010 GRAZ (AT)**

(74) Vertreter: **Babeluk, Michael**
**Florianigasse 26/3**
**1080 Wien (AT)**

(56) Entgegenhaltungen:
**DE-A1-102011 076 270**

**Beschreibung**

Die Erfindung betrifft ein Verfahren zum Test einer Bremsanlage eines Fahrzeuges, wobei Simulationsergebnisse für die Anpassung eines Tests auf einem Prüfstand herangezogen werden.

Dabei werden insbesondere Strömungssimulationsergebnisse herangezogen, um das thermische Verhalten der Bremsanlage an einem Testsystem anzupassen.

Zur Feststellung des Verhaltens des Fahrzeuges werden üblicherweise Simulationen oder Tests am gesamten Fahrzeug durchgeführt, beziehungsweise einzelne Komponenten getestet, wie im vorliegenden Fall für die Bremsanlage des Fahrzeuges.

Für die Bremsanlage ist eine Maximaltemperatur einer Bremskomponente, beispielsweise einer Bremsscheibe bei der es zur Schädigung, oder zum Versagen kommt ein wesentliches Grenzkriterium. Eine Kühlung der Bremsanlage soll dafür sorgen, dass die Bremsanlage diese Maximaltemperatur nicht erreicht, sie soll jedoch auch nicht mehr Kühlluft als nötig einlassen, da dadurch der Widerstand des Fahrzeuges erhöht wird.

Einen wesentlichen Einfluss auf die Bremsanlage hat die Temperaturerhöhung durch den Wärmeeintrag aufgrund von Reibung. Die entstandene Wärme wird hauptsächlich durch erzwungene Konvektion abtransportiert. Einfluss auf die Konvektion haben die Strömungsverhältnisse um Komponenten der Bremsanlage.

Weitere Einflussgrößen auf die Konvektion sind die Fahrzeuggeometrie, eine Längsgeschwindigkeit des Fahrzeuges, eine Fahrhöhe, ein Lenkwinkel, Seitenwinde und eine Umgebungstemperatur. Zur Durchführung der Versuche werden Lenkwinkel, Seitenwinde und Umgebungstemperatur vernachlässigt.

Aus der DE 10 2011 076 270 A1 ist ein Verfahren zur Prüfung und Simulation einer Radbremsanlage bekannt. Dabei werden bei einem Versuch auf der Teststrecke mit einem Testfahrzeug Messungen durchgeführt um die Strömungsverhältnisse um die Radbremsanlage festzustellen und damit eine Kühlkonstante b ermittelt. Anhand dieser Ergebnisse wird an einem Prüfstand eine Bremsenkühlvorrichtung angeordnet um die ermittelte Kühlkonstante b auch am Prüfstand zu erreichen. Dadurch soll eine realitätsnahe Prüfung ermöglicht werden. Nachteilig daran ist, dass zur Anpassung der Bedingungen am Prüfstand die Durchführung eines Versuchs auf der Teststrecke notwendig ist. Solche Versuche auf der Teststrecke sind aufwendig, zeitraubend und kostenintensiv und selbst kleine Veränderungen am Testfahrzeug sind nur mit sehr viel Aufwand durchführbar. Tests von Prototypen der Bremsanlage sind auch mit einem gewissen Sicherheitsrisiko für Testfahrer, das Testfahrzeug oder die Strecke verbunden.

Aufgabe der vorliegenden Erfindung ist es ein Verfahren anzugeben, das diese Nachteile vermeidet und ein Verfahren zur Verbesserung des Tests der Bremsanlage bereits vor Streckentests bereitstellt.

Das wird erfindungsgemäß dadurch erreicht, dass aus Geometriedaten des Fahrzeuges ein Strömungssimulationsmodell des Fahrzeuges erstellt wird, und ein Strömungssimulationsmodell des Prüfstandes erstellt wird und anhand des Strömungssimulationsmodells des Fahrzeuges ein Simulationsergebnis des Fahrzeuges in Hinsicht auf thermisches Verhalten der Bremsanlage - mit zumindest einer Eingangsgröße des Fahrzeuges errechnet wird, und eine Veränderung von zumindest einer Eingangsgröße des Prüfstandes in das Simulationsmodell des Prüfstandes solange durchgeführt wird, bis ein im Wesentlichen dem Simulationsergebnis des Fahrzeuges entsprechendes Simulationsergebnis des Prüfstandes des Simulationsmodelles des Prüfstandes erreicht wird und dass die zumindest eine Eingangsgröße des Prüfstandes als zumindest eine Eingangsgröße für einen Versuch in dem Prüfstand eingestellt wird und damit der Versuch durchgeführt wird.

Dadurch entsteht der Vorteil, dass zur Verbesserung des Verfahrens und zur Feststellung der wahren Strömungsverhältnisse kein teurer und aufwendiger Versuch auf der Teststrecke notwendig ist.

Durch den Einsatz dieser Simulationsmodelle können Änderungen der Fahrzeuggeometrie oder bei den verwendeten Materialen schnell einfließen und sind kostengünstig durchführbar.

Fehler an dem Strömungssimulationsmodell des Prüfstandes können besonders einfach und schnell erkannt werden, wenn anhand des Versuches das Strömungssimulationsmodell des Prüfstandes validiert wird. Dabei werden Eingangsgrößen und Simulationsergebnisse mit den gemessenen Größen und mit den getroffenen Annahmen verglichen und so etwaige Abweichungen und Fehlerquellen erkannt.

Ein besonders einfach zu handhabendes Simulationsmodell erreicht man, wenn zumindest als eine Eingangsgröße des Fahrzeuges eine Längsgeschwindigkeit des Fahrzeuges eingestellt wird - vorzugsweise als Längsgeschwindigkeitsverlauf des Fahrzeuges eingestellt wird - und in die Berechnung eingeht. Da die Längsgeschwindigkeit des Fahrzeuges bei einem Versuch leicht zu bestimmen ist und mit den Strömungsverhältnissen um die Bremsanlage in direktem Zusammenhang steht und diese wesentlich beeinflusst.

Es ist günstig, wenn als zumindest eine Eingangsgröße des Prüfstandes zumindest ein Luftmassenstrom - vorzugsweise ein Verlauf eines Luftmassenstromes - eingestellt wird und in die Berechnung eingeht. Dadurch entsteht der Vorteil, dass auf die Strömungsverhältnisse um die Bremsanlage leicht Einfluss genommen werden kann und so ihre direkte Auswirkung auf die Bremsanlange überprüft werden kann.

Aus der Eingangsgröße "Fahrzeuggeschwindigkeit" ergibt sich im einfachsten Fall ein Luftmassenstrom, der am Prüfstand dann eingestellt wird. Günstig ist es aus der Fahrzeuggeschwindigkeit mehrere Luftmassenströme zu berechnen, da dies im Vergleich zum Fahrzeug realistischer ist.

Um den Versuch beziehungsweise die Simulation besonders übersichtlich und einfach darzustellen, ist es vorteilhaft, wenn als Simulationsergebnis des Fahrzeuges zumindest eine Ausgangsgröße des Fahrzeuges berechnet wird, wobei die zumindest eine Ausgangsgröße des Fahrzeuges vorzugsweise eine Temperatur einer Bremskomponente des Fahrzeuges und besonders bevorzugt ein Temperaturverlauf der Bremskomponente des Fahrzeuges ist.

Um für verschiedene Bremsmanöver Simulationsergebnisse bereitstellen zu können, ist es günstig, wenn das Simulationsergebnis des Fahrzeuges mit zumindest einem Parameter des Fahrzeuges für das Simulationsmodell des Fahrzeuges berechnet wird - der vorzugsweise eine Bremsleistung ist und besonders bevorzugt ein Bremsleistungsverlauf ist. In einer anderen Ausführung kann die Bremsleistung, beziehungsweise der Bremsleistungsverlauf als eine weitere Eingangsgröße in die Simulation eingehen.

Um für eine Versuchsreihe mit unterschiedlichen Ausgangspunkten Eingangsgrößen des Prüfstandes bereitstellen zu können, ist es günstig, wenn aufgrund mehrerer Eingangsgrößen des Fahrzeuges mehrere Eingangsgrößen des Prüfstandes ermittelt werden und daraus eine Kennlinie erstellt wird. Diese Kennlinien werden als Korrekturkennlinien für den Prüfstand eingesetzt.

Der gleiche Vorteil entsteht, wenn abhängig von zumindest einem Parameter des Prüfstandes, der in das Strömungssimulationsmodell des Fahrzeuges und in das Strömungssimulationsmodell des Prüfstandes eingeht, ein Kennfeld mit Eingangsgröße des Fahrzeuges und Eingangsgröße des Prüfstandes erstellt wird - wobei vorzugsweise die Geometriedaten und eine Fahrhöhe Parameter darstellen.

Unter Geometriedaten sind die geometrischen Abmessungen des Fahrzeugs zu verstehen, wobei hierbei Augenmerk auf die Abmessungen der bremsrelevanten Fahrzeugteile wie beispielsweise Abmessungen der Radkästen, oder Abmessungen und Position der Luftzufuhr am Fahrzeug zu legen ist.

Unter der Fahrhöhe ist jene Höhe über der Fahrstrecke zu verstehen, auf welcher das Fahrzeug später im Realbetrieb betrieben wird.

In der Folge wird die Erfindung anhand der nicht einschränkenden Figuren näher erläutert. Es zeigen:

Fig. 1   ein Schema eines erfindungsgemäßen Verfahrens;

Fig. 2   ein Diagramm mit einem Längsgeschwindigkeitsverlauf des erfindungsgemäßen Verfahrens;

Fig. 3   ein Diagramm eines Verlaufes eines Wärmeübergangskoeffizienten;

Fig. 4   ein Diagramm von Wärmeübergangskoeffizienten über einer Längsgeschwindigkeit eines Fahrzeuges;

Fig. 5   ein Diagramm eines Bremsleistungsverlaufes;

Fig. 6   ein Diagramm von Wärmeströmen um eine Bremsanlage;

Fig. 7   ein Diagramm von Temperaturverläufen des Fahrzeuges einer Bremskomponente;

Fig. 8   ein Diagramm eines Ausschnitts des Längsgeschwindigkeitsverlaufes; und

Fig. 9   ein Diagramm der Temperaturverläufe des Fahrzeuges des Ausschnittes analog zu Fig.8.

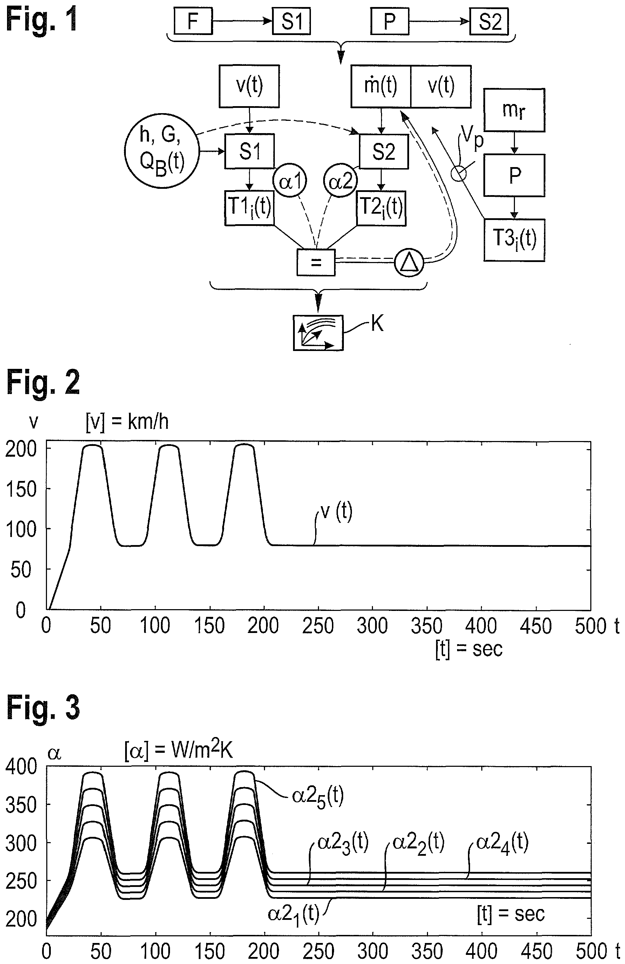

In einem erfindungsgemäßen Verfahren zum Test einer Bremsanlage B eines Fahrzeuges F, wie in Fig. 1 gezeigt, wird aus Geometriedaten G des Fahrzeuges F ein Strömungssimulationsmodell S1 des Fahrzeuges F erstellt. Von einem Prüfstand P zum Test der Bremsanlage B wird ein Strömungssimulationsmodell S2 des Prüfstandes P erstellt.

Mit den jeweiligen Eingangsgrößen wie beispielsweise der Fahrzeuggeschwindigkeit $v$ ist auch die jeweilige zeitabhängige Größe, hier der Verlauf der Fahrzeuggeschwindigkeit $v(t)$ gemeint. Anstatt eines einzelnen Luftmassenstromes $\dot{m}$ ist in der Regel eine Aufteilung in mehrere Luftmassenströme $\dot{m}_i$ notwendig um bessere Versuchsergebnisse zu erhalten.

In das Strömungssimulationsmodell S1 des Fahrzeuges F geht als Eingangsgröße des Fahrzeuges F die Fahrzeuggeschwindigkeit $v$ ein. Hier ist es darüber hinaus möglich, zusätzlich noch weitere optionale Parameter wie beispielsweise die Bremsleistung $\dot{Q}_B$ oder die Fahrhöhe $h$ einfließen zu lassen.

Als Ergebnis des Strömungssimulationsmodell S1 des Fahrzeuges F erhält man die Temperaturen der Bremsanlage $T1_i$ und die Luftmassenströme $\dot{m}1_i$, welche sich aus den Simulationsdaten, wie beispielsweise den Geometriedaten G des Fahrzeugs F ergeben.

In das Strömungssimulationsmodell S2 des Prüfstandes P gehen als Eingangsgrößen des Prüfstandes P die Fahrzeuggeschwindigkeit $v$, und die Luftmassenströme $\dot{m}2_i$ ein. Die Luftmassenströme $\dot{m}2_i$ sind variierbar und durch die Variation der Luftmassenströme $\dot{m}2_i$ wird auf das Ergebnis des Strömungssimulationsmodell S2 des Prüfstandes P Einfluss genommen. Als Ergebnis des Strömungssimulationsmodells S2 des Prüfstandes P erhält man die Temperaturen der Bremsanlage $T2_i$.

Üblicherweise entsprechen die Luftmassenströme $\dot{m}1_i$ nicht den Luftmassenströmen $\dot{m}2_i$. Die Temperaturen der Bremsanlagen $T1_i$ des Strömungssimulationsmodells S1 des Fahrzeuges F werden mir den Temperaturen der Bremsanlagen $T2_i$ des Strömungssimula-

tionsmodells S2 des Prüfstandes P verglichen. Wenn die Abweichung dieser beiden Simulationsergebnisse größer ist als ein maximal erlaubter Fehler, wird die Eingangsgröße $\dot{m}2_i$ des Prüfstandes P einer Veränderung Δ unterzogen und der Luftmassenstrom m2 variiert bzw. geregelt, bis bei dem Vergleich das Simulationsergebnis S2 des Prüfstandes P im Wesentlichen dem Strömungssimulationsergebnis S1 des Fahrzeuges F entspricht. Das heißt, dass die Temperaturen der Bremsanlagen $T2_i$ des Prüfstandes P annähernd den Temperaturen des Fahrzeuges F der Bremsanlagen $T1_i$ entsprechen, beziehungsweise der Temperaturverlauf $T2(t)$ des Prüfstands P annähernd dem Temperaturverlauf $T1(t)$ des Fahrzeuges F entspricht und die Abweichung kleiner als der maximal erlaubte Fehler ist. Die Ergebnisse der beiden Strömungssimulationsmodelle S1 und S2 sind nun im Wesentlichen gleich.

Weiters ist es möglich, unter der Verwendung der Wärmeübergangskoeffizienten $\alpha1$ und $\alpha2$ analog zur Verwendung der Temperaturen $T1$, $T2$ zu einem entsprechenden Ergebnis beim vorliegenden Verfahren zu gelangen, was in Fig. 1 als strichlierte Linie dargestellt wird. Dabei werden die Wärmeübergangskoeffizienten verglichen und die Luftmassenströme $\dot{m}2_i$ analog zur Verwendung der Temperaturen $T1$, $T2$ verändert.

Durch diese Vorgehensweise wird somit zumindest ein Luftmassenstrom $\dot{m}2_i$ für den Prüfstand P ermittelt, der der Kühlung der Bremsanlage durch die Längsgeschwindigkeit $v$ Fahrzeuges F entspricht.

Durch einen Versuch am Prüfstand P mit einem realen Luftmassenstrom $\dot{m}_r$ kann, wie in Fig. 1 gezeigt ist, das Simulationsmodell S2 des Prüfstandes P einer Validierung $V_P$ unterzogen werden. Dabei wird mit diesem Versuch am realen Prüfstand P eine Temperatur T3 des Versuchs ermittelt, welche ebenfalls in das Strömungssimulationsmodell S2 des Prüfstandes P einbezogen werden kann.

Durch Veränderung der Parameter wie beispielsweise der Fahrhöhe h oder der Geometriedaten G, können mehrere Kennlinien erstellt werden und daraus ein Kennfeld K erstellt werden.

In den Figuren Fig. 2 bis Fig. 9 sind beispielhafte Eingangsgrößen und Simulationsergebnisse anhand von Diagrammen gezeigt. In Fig. 2 ist ein Längsgeschwindigkeitsverlauf v(t) gezeigt. Die Längsgeschwindigkeit v wird in km/h angegeben und eine Zeit t in Sekunden (sec). Dabei wird das Fahrzeug F vom Stillstand (v=0 km/h) innerhalb von den ersten 100 sec auf über 200 km/h beschleunigt, kurze Zeit mit konstanter Längsgeschwindigkeit gefahren und dann auf zirka 80 km/h abgebremst und anschließend zirka 30 sec lang wieder mit konstanter Längsgeschwindigkeit gefahren. Anschließend wird erneut auf über 200 km/h beschleunigt und der vorangegangene Ablauf noch zweimal wiederholt. Nach 200 sec wird mit einer konstanten Längsgeschwindigkeit von 80 km/h gefahren.

In Fig. 3 ist der Verlauf des Wärmeübergangskoeffizienten $\alpha$ über der Zeit t gezeigt. Dafür wurde erfindungsgemäß zu der Längsgeschwindigkeit v ein Luftmassenstrom $\dot{m}$ für das Strömungssimulationsmodell S2 des Prüfstandes P als Eingangsgröße eingestellt und dementsprechend dann einer Veränderung Δ unterzogen. Somit ergeben sich Verläufe des Wärmeübergangskoeffizienten $\alpha2_1(t)$, $\alpha2_2(t)$, $\alpha2_3(t)$, $\alpha2_4(t)$, $\alpha2_5(t)$.

Der Wärmeübergangskoeffizient $\alpha$ verläuft analog zum Geschwindigkeitsverlauf v(t) in Fig. 2, da die Annahme getroffen wird, dass der Wärmeübertragungskoeffizient $\alpha$ von der Geschwindigkeit v linear abhängig ist. In Fig. 3 ist zu erkennen, dass der Wärmeübertragungskoeffizient $\alpha$ im gezeigten Ausführungsbeispiel bei einer Geschwindigkeit v von ungefähr 200 km/h zwischen 300 W/m²K und 380 W/m²K schwankt, wenn der angenommene Luftmassenstrom $\dot{m}$ der Veränderung Δ unterzogen wird.

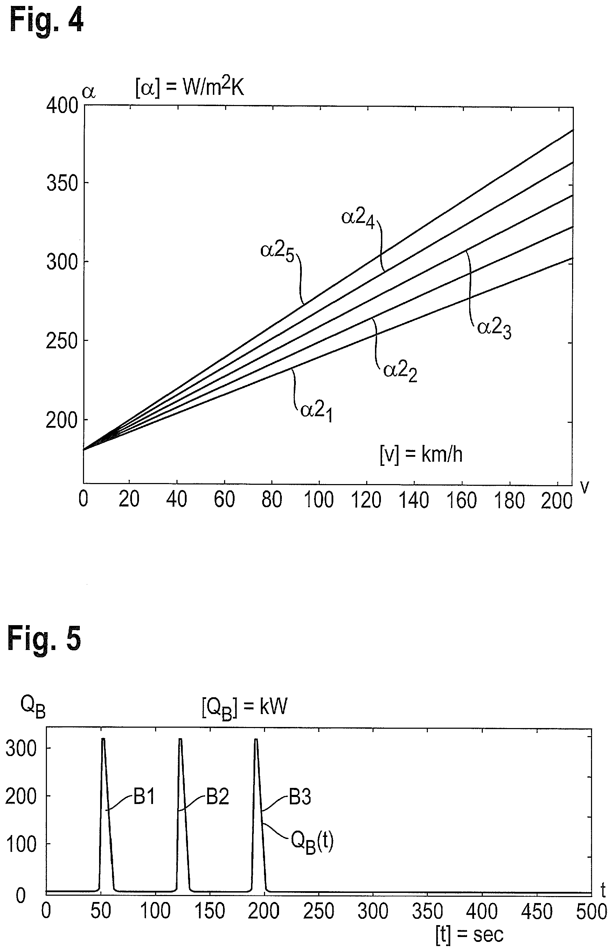

In Fig. 4 ist der Wärmeübergangskoeffizient $\alpha$ in Abhängigkeit der Geschwindigkeit v gezeigt.

Durch einen ersten Bremsvorgang B1 wird eine Bremsleistung $Q_B$ aufgebracht. Der Bremsleistungsverlauf $Q_B(t)$ übersteigt bei dem ersten Bremsvorgang B1, bei einem zweiten Bremsvorgang B2 und bei einem dritten Bremsvorgang B3 jeweils 300 kW.

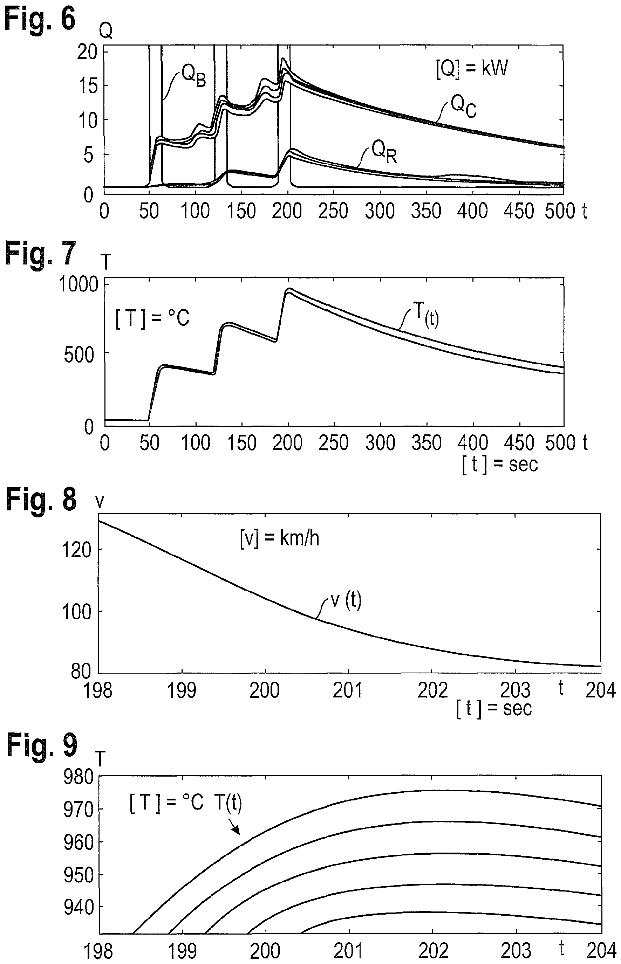

In Fig. 6 sind die übertragenen Wärmen gezeigt. Dabei ist die Bremsleistung $Q_B$ nur bis zu 20 kW gezeigt, entspricht aber ihrem Verlauf in Fig. 5. Eine durch Konvektion (Convection) übertragene Wärme $Q_C$ beginnt von null und steigt mit dem ersten Bremsvorgang B1 auf ungefähr 7 kW und fällt dann nochmals leicht und aufgrund der zunehmenden Geschwindigkeit steigt sie vor dem zweiten Bremsvorgang B2 nochmals, bis sie während des zweiten Bremsvorganges B2 stark ansteigt und sich der Vorgang nochmals wiederholt. Nach dem dritten Bremsvorgang, bei dem die durch Konvektion übertragenen Wärme zwischen 15 kW und 18 kW schwankt nimmt diese danach ab. Eine durch Strahlung (Radiation) übertragene Wärme $Q_R$ ist nach dem ersten Bremsvorgang B1 verschwindend gering, nach dem zweiten Bremsvorgang B2 liegt sie bei zirka 3 kW und nach dem dritten Bremsvorgang B3 liegt sie bei zirka 5 kW. Daraus ist erkennbar, dass die durch Konvektion übertragene Wärme $Q_C$ den größten Einfluss auf die Temperatur hat.

Die Bremsleistung $Q_B$ berechnet sich mit Masse m des Fahrzeuges F und Längsgeschwindigkeit v zu

$$Q_B = \frac{m * (\frac{v}{2})^2}{t}.$$

Die durch Strahlung übertragene Wärme QR berechnet sich mit einer Fläche A einer Oberfläche O der Bremsscheibe, einem Emissionsgrad $\varepsilon$, der Stefan-Boltzmann-Konstante $\sigma$, einer Oberflächentemperatur $T_O$, einer Umgebungstemperatur $T_U$ über

$$Q_R = A * \varepsilon * \sigma * (T_O^4 - T_U^4).$$

Die durch Konvektion übertragen Wärme Q_C ist abhängig von dem Wärmeübertragungskoeffizienten $\alpha$ und wird mit der Formel

$$Q_C = A * \alpha * (T_O - T_U)$$

berechnet.

Ein in Fig. 7 gezeigter Temperaturverlauf T(t) der Bremskomponente, der Bremsscheibe, steigt mit dem ersten Bremsvorgang B1 auf ungefähr 430 °C und mit dem zweiten Bremsvorgang B2 auf ungefähr 700 °C und mit dem dritten Bremsvorgang auf mehr als 930 °C. Zwischen den einzelnen Bremsvorgängen B1, B2, B3 fällt die Temperatur T ein wenig.

Fig. 6, Fig. 7 und Fig. 9 sind für die einzelnen Wärmeübertragungskoeffizienten $\alpha2_1(t)$, $\alpha2_2(t)$, $\alpha2_3(t)$, $\alpha2_4(t)$, $\alpha2_5(t)$ die einzelnen Verläufe der anderen Größen aufgezeichnet.

Der reale Luftmassenstrom $\dot{m}_r$ ist abhängig von einem Durchmesser eines Bremskanals und von der Geschwindigkeit v. Die Erfindung gibt ein Verfahren zur Berechnung oder Bestimmung des benötigten Luftmassenstroms $\dot{m}$ an.

Über eine Wärmebilanz um die Bremsscheibe werden im Strömungssimulationsmodell S1 des Fahrzeuges F und im zweiten Strömungssimulationsmodell S2 des Prüfstandes P die unbekannten Größen ermittelt. In die Bremsscheibe wird durch die Bremsleistung Q_B Wärme eingebracht. Von der Bremsscheibe ist das Material und ihre Geometrie bekannt.

**Patentansprüche**

1. Verfahren zum Test einer Bremsanlage (B) eines Fahrzeuges (F), wobei Simulationsergebnisse für die Anpassung eines Tests auf einem Prüfstand (P) herangezogen werden, **dadurch gekennzeichnet, dass** aus Geometriedaten (G) des Fahrzeuges (F) ein Strömungssimulationsmodell (S1) des Fahrzeuges (F) erstellt wird, und ein Strömungssimulationsmodell (S2) des Prüfstandes (P) erstellt wird und anhand des Strömungssimulationsmodells (S1) des Fahrzeuges (F) ein Simulationsergebnis für das Fahrzeug (F) in Hinsicht auf thermisches Verhalten der Bremsanlage des Fahrzeuges, mit zumindest einer Eingangsgröße des Fahrzeuges (F) errechnet wird, und eine Veränderung ($\Delta$) von zumindest einer Eingangsgröße für den Prüfstand (P) in das Strömungssimulationsmodell (S2) des Prüfstands (P) solange durchgeführt wird, bis ein im Wesentlichen dem Simulationsergebnis für das Fahrzeug (F) entsprechendes Simulationsergebnis für den Prüfstand (P) des Strömungssimulationsmodells (S2) des Prüfstands (P) erreicht wird und dass die zumindest eine Eingangsgröße für den Prüfstand (P) als zumindest eine Eingangsgröße für einen Versuch in dem Prüfstand (P) eingestellt wird und damit der Versuch durchgeführt wird.

2. Verfahren nach Anspruch 1, **dadurch gekennzeichnet, dass** anhand des Versuches das Simulationsmodell (S2) des Prüfstands (P) validiert wird.

3. Verfahren nach Anspruch 1, 2, **dadurch gekennzeichnet, dass** zumindest als eine Eingangsgröße des Fahrzeuges (F) eine Längsgeschwindigkeit (v) des Fahrzeuges (F) eingestellt wird - vorzugsweise als Längsgeschwindigkeitsverlauf (v(t)) des Fahrzeuges (F) eingestellt wird - und in die Berechnung eingeht.

4. Verfahren nach einem der Ansprüche 1 bis 3, **dadurch gekennzeichnet, dass** als zumindest eine Eingangsgröße des Prüfstands (P) zumindest ein Luftmassenstrom (m·) - vorzugsweise ein Verlauf eines Luftmassenstromes (m· (t)) - eingestellt wird und in die Berechnung eingeht.

5. Verfahren nach einem der Ansprüche 1 bis 4, **dadurch gekennzeichnet, dass** als Simulationsergebnis des Fahrzeuges (F) zumindest eine erste Ausgangsgröße für das Fahrzeug (F) berechnet wird, wobei die zumindest eine erste Ausgangsgröße für das Fahrzeug (F) eine erste Temperatur (T1) einer Bremskomponente und bevorzugt ein erster Temperaturverlauf (T1(t)) der Bremskomponente ist.

6. Verfahren nach einem der Ansprüche 1 bis 5, **dadurch gekennzeichnet, dass** das Simulationsergebnis des Fahrzeuges (F) mit zumindest einem ersten Parameter für das Simulationsmodell (S1) des Fahrzeuges (F) berechnet wird - der eine Bremsleistung (QB) ist und bevorzugt ein Bremsleistungsverlauf (QB(t)) ist.

7. Verfahren nach einem der Ansprüche 1 bis 6, **dadurch gekennzeichnet, dass** aufgrund mehrerer Eingangsgrößen für das Fahrzeug (F) mehrere Eingangsgrößen für den Prüfstand (P) ermittelt werden und daraus eine Kennlinie erstellt wird.

8. Verfahren nach Anspruch 7, **dadurch gekennzeichnet, dass** abhängig von zumindest einem zweiten Parameter, der in das Strömungssimulationsmodell (S1) für das Fahrzeug (F) und in das Strömungssimulationsmodell (S2) für den Prüfstand (P) eingeht, ein Kennfeld (K) mit Eingangsgröße für das Fahrzeug (F) und Eingangsgröße für den Prüfstand (P) erstellt wird.

## Claims

1. A method for testing a brake system (B) of a vehicle (F), wherein simulation results are used for adapting a test on a test stand (P), **characterised in that** a flow simulation model (S1) of the vehicle (F) is created from geometric data (G) of the vehicle (F), and a flow simulation model (S2) of the test stand (P) is created, and based on the flow simulation model (S1) of the vehicle (F) a simulation result for the vehicle (F) is calculated with at least one input variable of the vehicle (F) with respect to thermal behavior of the brake system of the vehicle, and a change (∆) of at least one input variable for the test stand (P) in the flow simulation model (S2) of the test stand (P) is performed until a simulation result for the test stand (P) of the flow simulation model (S2) of the test stand (P) is achieved, which simulation result corresponds essentially to the simulation result for the vehicle (F), and **in that** the at least one input variable for the test stand (P) is set as at least one input variable for a test in the test stand (P) and the test is thus carried out.

2. A method according to claim 1, **characterised in that** based on the test, the simulation model (S2) of the test stand (P) is validated.

3. A method according to claim 1, 2, **characterised in that** a longitudinal velocity (v) of the vehicle (F) is set at least as an input variable of the vehicle (F), preferably as a longitudinal velocity curve (v(t)) of the vehicle (F), and is entered into the calculation.

4. A method according to one of the claims 1 to 3, **characterised in that** at least one air mass flow (m'), preferably a curve of an air mass flow (m'(t)), is set as at least one input variable of the test stand (P) and is entered into the calculation.

5. A method according to one of the claims 1 to 4, **characterised in that** at least one first output variable for the vehicle (F) is calculated as the simulation result of the vehicle (F), wherein the at least one first output variable for the vehicle (F) is a first temperature (T1) of a brake component and preferably a first temperature curve (T1(t)) of the brake component.

6. A method according to one of the claims 1 to 5, **characterised in that** the simulation result of the vehicle (F) is calculated with at least one first parameter for the simulation model (S1) of the vehicle (F), which is a braking power (QB) and particularly preferably a braking power curve (QB(t)).

7. A method according to one of the claims 1 to 6, **characterised in that** due to a plurality of input variables for the vehicle (F), a plurality of input variables for the test stand (P) are determined and a characteristic curve is created therefrom.

8. A method according to claim 7, **characterised in that** depending on at least one second parameter, which is entered into the flow simulation model (S1) for the vehicle (F) and into the simulation model (S2) for the test stand (P), a characteristic map (K) is created with input variable for the vehicle (F) and input variable for the test stand (P).

## Revendications

1. Procédé permettant de tester une installation de freinage (B) d'un véhicule (F), selon lequel on utilise des résultats de simulation pour ajustement d'un test sur un banc d'essai (P),
**caractérisé en ce qu'**
à partir de données géométriques (G) du véhicule (F), on établit un modèle de simulation de l'écoulement aérodynamique (S1) du véhicule, et on établit un modèle de simulation de l'écoulement aérodynamique (S2) du banc d'essai (P), et sur la base du modèle de simulation de l'écoulement aérodynamique (S1) du véhicule (F) on calcule un résultat de simulation pour le véhicule (F) concernant le comportement thermique de l'installation de freinage du véhicule, avec au moins une grandeur d'entrée du véhicule (F), et on effectue une modification (∆) d'au moins une grandeur d'entrée pour le banc d'essai (P) dans le modèle de simulation de l'écoulement aérodynamique (S2) du banc d'essai (P) jusqu'à ce qu'un résultat de simulation pour le banc d'essai (P) du modèle de simulation de l'écoulement aérodynamique (S2) du banc d'essai (P) correspondant essentiellement au résultat de simulation pour le véhicule (F), soit obtenu, et on règle la grandeur d'entrée pour le banc d'essai (P) en tant que grandeur d'entrée pour un essai dans le banc d'essai (P), et l'on effectue ainsi l'essai.

2. Procédé conforme à la revendication 1,
**caractérisé en ce que**
sur le fondement de l'essai, on valide le modèle de simulation (S2) du banc d'essai (P).

3. Procédé conforme à la revendication 1 ou 2,
**caractérisé en ce qu'**
on règle au moins la vitesse longitudinale (v) du véhicule (F) en tant que grandeur d'entrée du véhicule (F), et de préférence on règle les variations en fonction du temps de la vitesse longitudinale (v(t)) du véhicule (F) et on en tient compte dans le calcul.

4. Procédé conforme à l'une des revendications 1 à 3,
**caractérisé en ce qu'**
en tant que grandeur d'entrée du banc d'essai (P), on utilise au moins le débit massique d'air (ṁ) et de préférence les variations du débit massique d'air (ṁ(t)) et on en tient compte dans le calcul.

5. Procédé conforme à l'une des revendications 1 à 4, **caractérisé en ce qu'**
en tant que résultat de simulation du véhicule (F) on calcule au moins une première grandeur de sortie pour le véhicule (F), et la première grandeur de sortie pour le véhicule (F) est une première température (T1) d'un composant de freinage et de préférence les variations d'une première température (T1(t)) du composant de freinage.

6. Procédé conforme à l'une des revendications 1 à 5, **caractérisé en ce qu'**
on calcule le résultat de simulation du véhicule (F) avec au moins un premier paramètre pour le modèle de simulation (S1) du véhicule (F) qui est la puissance de freinage (QB) et de préférence les variations de la puissance de freinage (QB(t)).

7. Procédé conforme à l'une des revendications 1 à 6, **caractérisé en ce que**
sur le fondement de plusieurs grandeurs d'entrée pour le véhicule (F), on évalue plusieurs grandeurs d'entrée pour le banc d'essai (P), et à partir de celles-ci on établit une caractéristique.

8. Procédé conforme à la revendication 7, **caractérisé en ce qu'**
en fonction d'au moins un second paramètre qui est pris en considération dans le modèle de simulation de l'écoulement aérodynamique (S1) du véhicule (F) et dans le modèle de simulation de l'écoulement aérodynamique (S2) du banc d'essai (P) on établit un champ de caractéristiques (K) avec des grandeurs d'entrée pour le véhicule (F) et des grandeurs d'entrée pour le banc d'essai (P).

## Fig. 1

## Fig. 2

## Fig. 3

# Fig. 4

$\alpha$     $[\alpha] = W/m^2K$

$[v] = km/h$

$\alpha2_5$
$\alpha2_4$
$\alpha2_3$
$\alpha2_2$
$\alpha2_1$

# Fig. 5

$Q_B$     $[Q_B] = kW$

B1   B2   B3

$Q_B(t)$

$[t] = sec$

**Fig. 6**

**Fig. 7**

**Fig. 8**

**Fig. 9**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102011076270 A1